# EUROPÄISCHE PATENTSCHRIFT

(11) **EP 3 465 781 B1**
(45) Veröffentlichungstag und Bekanntmachung des Hinweises auf die Patenterteilung: **18.03.2020**
(21) Anmeldenummer: 17719592.2
(22) Anmeldetag: 26.04.2017
(51) Int. Cl.: H01L 35/30, H01L 35/32

(54) **THERMOELEKTRISCHE ANORDNUNG, INSBESONDERE THERMOELEKTRISCHE SENSORANORDNUNG, SOWIE ENTSPRECHENDES HERSTELLUNGSVERFAHREN**
THERMOELECTRIC ASSEMBLY, IN PARTICULAR THERMOELECTRIC SENSOR ASSEMBLY, AND CORRESPONDING PRODUCTION METHOD
ENSEMBLE THERMOÉLECTRIQUE, NOTAMMENT ENSEMBLE CAPTEUR THERMOÉLECTRIQUE, ET PROCÉDÉ DE FABRICATION CORRESPONDANT

(30) Priorität: 30.05.2016 DE 102016209315
(43) Veröffentlichungstag der Anmeldung: 10.04.2019
(73) Patentinhaber: Robert Bosch GmbH, 70442 Stuttgart (DE)
(72) Erfinder: ZOLLER, Tobias, 72622 Nuertingen (DE); EHRENPFORDT, Ricardo, 70825 Korntal-Muenchingen (DE); NAGEL, Cristian, 70565 Stuttgart (DE)
(86) Internationale Anmeldenummer: PCT/EP2017/059899
(87) Internationale Veröffentlichungsnummer: WO 2017/207174

(56) Entgegenhaltungen:
- EP-A2- 2 876 697
- WO-A2-2013/107637
- DE-A1-102011 075 661
- DE-A1-102012 208 745

## Beschreibung

Die Erfindung betrifft eine thermoelektrische Anordnung, insbesondere thermoelektrische Sensoranordnung, sowie ein entsprechendes Herstellungsverfahren.

### Stand der Technik

Das "Internet der Dinge" (Internet of Things, IoT) wird als eine der wichtigsten zukünftigen Entwicklungen in der Informationstechnologie bezeichnet. Unter dem IoT versteht man, dass nicht nur Menschen Zugang zum Internet haben und über dieses vernetzt sind, sondern dass auch Geräte über das Internet miteinander vernetzt sind. Ein Bereich des "Internet der Dinge" zielt insbesondere in Richtung Produktions- und Hausautomatisierung, z.B. zur Temperaturmessung mittels Sensoren. Derzeit werden Anstrengungen unternommen um Sensoren weiterzuentwickeln, welche gleichzeitig die benötigte elektrische Energie auf Basis von "Energy Harvesting" beispielsweise aus der Umwelt gewinnen.

Die DE 198 45 104 A1 offenbart ein Verfahren zum Herstellen eines thermoelektrischen Wandlers mit einer Mehrzahl von in Reihe geschalteten Thermoelementzellen, die insbesondere mittels einer Mehrzahl von ersten elektrischen Leiterbahnen seriell miteinander verbunden sind.

Aus der EP 2 876 607 A2 ist bereits ein elektronisches Modul, sowie ein Verfahren zum Betreiben und zum Herstellen eines solchen Moduls bekannt. Das elektronische Modul weist einen thermoelektrischen Generator auf, wobei die erzeugte elektrische Energie verwendet wird, um ein elektronisches Bauelement zu betreiben. Das elektronische Modul erfasst hierbei eine Mehrzahl elektrischer Leiterplatten, die einen mechanisch festen Verbund bilden. Der Verbund ist von einem Bauteilgehäuse umgeben.

### Offenbarung der Erfindung

Die Erfindung schafft eine thermoelektrische Anordnung, insbesondere thermoelektrische Sensoranordnung und ein entsprechendes Herstellungsverfahren mit den Merkmalen der unabhängigen Patentansprüche.

Bevorzugte Weiterbildungen sind Gegenstand der jeweiligen Unteransprüche.

### Vorteile der Erfindung

Die der vorliegenden Erfindung zugrunde liegende Idee liegt darin, durch Anordnen oder Integration einer Leiterplatte mit thermoelektrischem Bauelement innerhalb eines Gehäuses, eine thermoelektrische Anordnung weiterzuentwickeln, so dass das thermoelektrische Bauelement effizient betrieben werden kann. Ferner kann das thermoelektrische Bauelement durch die hier beschrieben thermoelektrischen Anordnung vor äußeren Einflüssen, beispielsweise Luftfeuchte oder Erschütterungen, geschützt werden.

Die thermoelektrische Anordnung, insbesondere thermoelektrische Sensoranordnung, umfasst hierbei zumindest eine Leiterplatte, zumindest ein thermoelektrisches Bauelement mit einer Kaltseite und einer Warmseite, wobei das zumindest eine thermoelektrische Bauelement zu der zumindest einen Leiterplatte elektrisch kontaktiert ist. Das zumindest eine thermoelektrische Bauelement kann beispielsweise mit der Warmseite auf der zumindest einen Leiterplatte angeordnet sein. Ferner umfasst die thermoelektrische Anordnung ein Gehäuse mit einer Abdeckung, wobei die Leiterplatte und das zumindest eine thermoelektrische Bauelement in dem bzw. innerhalb des Gehäuses angeordnet sind. Das heißt, dass die Leiterplatte und das zumindest eine thermoelektrische Bauelement vollständig in dem Gehäuse angeordnet sein können. Hierbei ist das zumindest eine thermoelektrische Bauelement an der Kaltseite mit einer wärmeabführenden Struktur und an der Warmseite mit einer der Abdeckung abgewandten Seite des Gehäuses mittels einer thermischen Leitereinrichtung verbunden und die zumindest eine Leiterplatte ist durch die thermische Leitereinrichtung weitestgehend freistehend in dem Gehäuse angeordnet.

Unter dem Begriff "weitestgehend" wird im vorliegenden Zusammenhang verstanden, dass ein Anordnen der Leiterplatte insbesondere ausschließlich durch die thermische Leitereinrichtung durchführbar ist.

Unter dem Begriff "freistehend" wird im vorliegenden Zusammenhang verstanden, dass das Gehäuse weitere Komponenten umfassen kann, welche die Leiterplatte stützen können. Derartige Komponenten sind als eine Weiterbildung der thermoelektrischen Anordnung zu verstehen. Eine freistehende Position bzw. Stellung der Leiterplatte in dem Gehäuse ist durch die thermische Leitereinrichtung realisierbar.

Unter "wärmeabführende Struktur" wird in vorliegenden Zusammenhang eine Struktur verstanden, durch welche eine bessere, effizientere und/oder schnellere Abführung von Wärme bzw. Hitze Gewähr leistbar ist. Insbesondere kann hierbei eine Struktur zur Erhöhung einer Wärmeabfuhr verstanden werden.

Ferner betrifft die Erfindung ein Verfahren zum Herstellen einer thermoelektrischen Anordnung, insbesondere einer thermoelektrischen Sensoranordnung. Das Herstellungsverfahren umfasst hierbei ein Bereitstellen der zumindest einen Leiterplatte, ein Bereitstellen des zumindest einen thermoelektrischen Bauelements mit der Kaltseite und der Warmseite, wobei das zumindest eine thermoelektrische Bauelement zu der zumindest einen Leiterplatte elektrisch kontaktiert wird. Ferner wird das Gehäuse mit der Abdeckung bereitgestellt. Die zumindest eine Leiterplatte und das zumindest eine thermoelektrische Bauelement werden in dem Gehäuse angeordnet und das zumindest eine thermoelektrische Bauelement wird an der Kaltseite mit der wärmeabführenden Struktur und an der Warmseite mit der der Abdeckung abgewandten Seite des Gehäuses mittels der thermischen Leitereinrichtung verbunden, wobei die zumindest eine Leiterplatte durch die thermische Leitereinrichtung weitestgehend freistehend in dem Gehäuse angeordnet wird.

Bei dem thermoelektrischen Bauelement handelt es sich vorliegend um einen thermoelektrischen Generator (TEG), der unter Einwirkung eines Temperaturgradienten nach dem Seebeck-Effekt elektrische Energie erzeugt. Ein Einstellen des Temperaturgradienten wird vorliegend insbesondere durch die thermische Leitereinrichtung und eine Dimensionierung und/oder Materialbeschaffenheit des Gehäuses mit der Abdeckung verbessert. Die thermische Leitereinrichtung kann insbesondere die zumindest eine Leiterplatte mit dem zumindest einen thermoelektrischen Bauelement von einer Bodenfläche des Gehäuses bis zu der wärmeabführenden Struktur oder bis oder durch die Abdeckung hinaus verbinden. Somit kann beispielsweise bei einer entsprechenden Höhe des Gehäuses das zumindest eine thermoelektrische Bauelement mittels der thermischen Leitereinrichtung besonders effizient betrieben werden, da sich insbesondere ein Temperaturunterschied an der Kaltseite sowie der Warmseite einfach einstellt. Beispielsweise kann die Höhe des Gehäuses 17 mm bis 25 mm, insbesondere 20 mm, betragen.

Auf Basis der thermoelektrischen Bauelemente lassen sich somit autonome thermoelektrische Sensoranordnungen oder Sensorsysteme aufbauen, die zum Beispiel an heißen Oberflächen von Industrieanlagen angebracht werden können und durch einen sich einstellenden Temperaturgradient an dem zumindest einen thermoelektrischen Bauelement beispielsweise Sensoren mit Energie versorgen. Die Sensoren, beispielsweise MEMS, können hierbei auf einer Oberseite oder Unterseite der zumindest einen Leiterplatte angeordnet sein.

Gemäß einer bevorzugten Weiterbildung kann die thermische Leitereinrichtung insbesondere ein Metall, beispielsweise Kupfer, Aluminium oder Edelstahl umfassen. Denkbar sind auch Legierungen aus gut wärmeleitenden metallischen Werkstoffen.

Gemäß einer weiteren bevorzugten Weiterbildung ist das zumindest eine thermoelektrische Bauelement auf der zumindest einen Leiterplatte mechanisch angebracht. So lässt sich insbesondere ein einfacher Aufbau der thermoelektrischen Anordnung realisieren.

Gemäß einer weiteren bevorzugten Weiterbildung ist das zumindest eine thermoelektrische Bauelement unmittelbar mit der thermischen Leitereinrichtung mechanisch kontaktiert. So lässt sich ein Temperaturgradient in dem zumindest einem thermoelektrischen Bauelement besonders effizient einstellen.

Gemäß einer weiteren bevorzugten Weiterbildung umfasst die zumindest eine Leiterplatte thermische Kontaktstellen, welche vertikal durch die zumindest eine Leiterplatte reichen, wobei das zumindest eine thermoelektrische Bauelement auf der thermischen Kontaktstelle angeordnet ist und die thermische Kontaktstelle gemeinsam mit dem zumindest einen thermoelektrischen Bauelement sowie der thermische Leitereinrichtung einen übereinander angeordneten Stapel bildet. Unter "vertikal" wird im vorliegenden Zusammenhang eine Richtung quer zu einer Hauptausdehnungsrichtung der Leiterplatte verstanden. So lässt sich der Temperaturgradient innerhalb des zumindest einen thermoelektrischen Bauelements besonders effizient einstellen. Ferner lässt sich eine platzsparende Bauweise realisieren.

Gemäß einer weiteren bevorzugten Weiterbildung sind die thermischen Kontaktstellen an diagonal gegenüberliegenden Seiten der Leiterplatte angeordnet. So lässt sich ein gegenseitiges thermisches Beeinflussen zwischen den thermischen Bauelementen auf der Leiterplatte minimieren.

Gemäß einer weiteren bevorzugten Weiterbildung ist die wärmeabführende Struktur Teil eines Kühlkörpers, welcher die Abdeckung überdeckt und wobei die thermische Leitereinrichtung durch eine Öffnung der Abdeckung durchführbar ist. So lässt sich die thermoelektrische Anordnung einfach hinsichtlich eines industriellen Einsatzes adaptieren.

Gemäß einer weiteren bevorzugten Weiterbildung ist die Abdeckung von dem Gehäuse oder von der thermischen Leitereinrichtung durch zumindest ein Dichtelement thermisch entkoppelt. So lässt sich Wärme über die Kaltseite des zumindest einen thermoelektrischen Bauelements effizient abführen.

Gemäß einer weiteren bevorzugten Weiterbildung ist die wärmeabführende Struktur Teil der Abdeckung, welche das Gehäuse überdeckt. So lässt sich die thermoelektrische Anordnung einfach miniaturisieren.

Gemäß einer weiteren bevorzugten Weiterbildung ist in dem Gehäuse eine Vergussmasse angeordnet und die Vergussmasse stabilisiert die Leiterplatte mechanisch. So lässt sich die hier beschriebene thermoelektrische Anordnung insbesondere vor äußeren Erschütterungen schützen. Die Vergussmasse kann insbesondere derartige Erschütterungen kompensieren bzw. absorbieren. Ferner kann die Vergussmasse eine Robustheit der thermoelektrischen Anordnungen gegenüber Erschütterungen erhöhen.

Gemäß einer weiteren bevorzugten Weiterbildung umfassen das Gehäuse und/oder die Abdeckung ein thermisch-leitfähiges Material. So lässt sich eine Wärmezufuhr bzw. Wärmeabfuhr mittels der thermischen Leitereinrichtung zusätzlich optimieren.

Die hier beschriebenen Weiterbildungen bzw. Merkmale für die thermoelektrische Anordnung sind ebenfalls für das Verfahren zum Herstellen der thermoelektrischen Anordnung offenbart sowie umgekehrt.

### Kurze Beschreibung der Zeichnungen

Weitere Merkmale und Vorteile der vorliegenden Erfindung werden nachfolgend anhand von Ausführungsformen mit Bezug auf die Figuren erläutert.

Es zeigen:
- Fig. 1: schematische Darstellung einer Sensoranordnung gemäß einer Ausführungsform der vorliegenden Erfindung;
- Fig. 2: schematische Querschnittsansicht zur Erläuterung einer thermoelektrischen Anordnung, insbesondere thermoelektrische Sensoranordnung, und eines entsprechenden Herstellungsverfahrens gemäß einer ersten Ausführungsform der vorliegenden Erfindung;
- Fig. 3: schematische Querschnittsansicht zur Erläuterung einer thermoelektrischen Anordnung, insbesondere thermoelektrische Sensoranordnung, und eines entsprechenden Herstellungsverfahrens gemäß einer zweiten Ausführungsform der vorliegenden Erfindung;
- Fig. 4: schematische Querschnittsansicht zur Erläuterung einer thermoelektrischen Anordnung, insbesondere thermoelektrische Sensoranordnung, und eines entsprechenden Herstellungsverfahrens gemäß einer dritten Ausführungsform der vorliegenden Erfindung;
- Fig. 5: schematische Querschnittsansicht zur Erläuterung einer thermoelektrischen Anordnung, insbesondere thermoelektrische Sensoranordnung, und eines entsprechenden Herstellungsverfahrens gemäß einer vierten Ausführungsform der vorliegenden Erfindung;
- Fig. 6: schematische Querschnittsansicht zur Erläuterung einer thermoelektrischen Anordnung, insbesondere thermoelektrische Sensoranordnung, und eines entsprechenden Herstellungsverfahrens gemäß einer fünften Ausführungsform der vorliegenden Erfindung;
- Fig. 7: schematische Querschnittsansicht zur Erläuterung einer thermoelektrischen Anordnung, insbesondere thermoelektrische Sensoranordnung, und eines entsprechenden Herstellungsverfahrens gemäß einer sechsten Ausführungsform der vorliegenden Erfindung;
- Fig. 8: schematische Querschnittsansicht zur Erläuterung einer thermoelektrischen Anordnung, insbesondere thermoelektrische Sensoranordnung, und eines entsprechenden Herstellungsverfahrens gemäß einer siebten Ausführungsform der vorliegenden Erfindung;
- Fig. 9: schematische Querschnittsansicht zur Erläuterung einer thermoelektrischen Anordnung, insbesondere thermoelektrische Sensoranordnung, und eines entsprechenden Herstellungsverfahrens gemäß einer achten Ausführungsform der vorliegenden Erfindung;
- Fig. 10: schematische Querschnittsansicht zur Erläuterung einer thermoelektrischen Anordnung, insbesondere thermoelektrische Sensoranordnung, und eines entsprechenden Herstellungsverfahrens gemäß einer neunten Ausführungsform der vorliegenden Erfindung;
- Fig. 11: schematische Querschnittsansicht zur Erläuterung einer thermoelektrischen Anordnung, insbesondere thermoelektrische Sensoranordnung, und eines entsprechenden Herstellungsverfahrens gemäß einer zehnten Ausführungsform der vorliegenden Erfindung;
- Fig. 12: schematische Querschnittsansicht zur Erläuterung einer thermoelektrischen Anordnung, insbesondere thermoelektrische Sensoranordnung, und eines entsprechenden Herstellungsverfahrens gemäß einer elften Ausführungsform der vorliegenden Erfindung;
- Fig. 13: schematische Querschnittsansicht zur Erläuterung einer thermoelektrischen Anordnung, insbesondere thermoelektrische Sensoranordnung, und eines entsprechenden Herstellungsverfahrens gemäß einer zwölften Ausführungsform der vorliegenden Erfindung;
- Fig. 14: schematische Querschnittsansicht zur Erläuterung einer thermoelektrischen Anordnung, insbesondere thermoelektrische Sensoranordnung, und eines entsprechenden Herstellungsverfahrens gemäß einer dreizehnten Ausführungsform der vorliegenden Erfindung; und
- Fig. 15: ein Flussdiagramm zur Erläuterung des Herstellungsverfahrens gemäß den hier beschriebenen alternativen Ausführungsformen gemäß Figuren 1-14.

### Ausführungsformen der Erfindung

In den Figuren bezeichnen gleiche Bezugszeichen gleiche bzw. funktionsgleiche Elemente bzw. Komponenten.

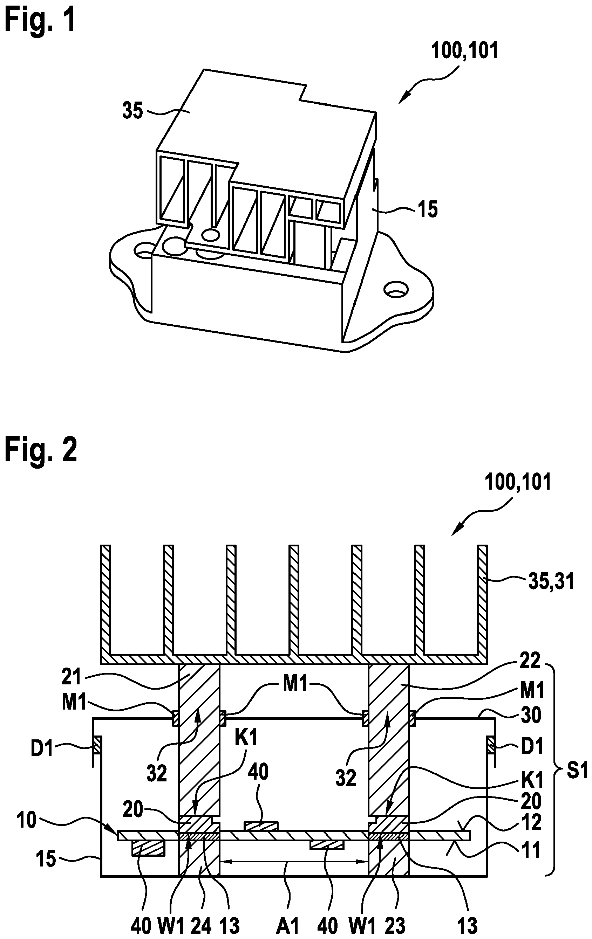

Figur 1 ist schematische Darstellung einer Sensoranordnung gemäß einer Ausführungsform der vorliegenden Erfindung.

In Figur 1 bezeichnet Bezugszeichen 101 eine thermoelektrische Anordnung 100, insbesondere eine thermoelektrische Sensoranordnung 101 mit einem Gehäuse 15 und einem Kühlkörper 35. Figur 1 zeigt eine beispielhafte autonome Sensoranordnung 101. Zum detaillierten Aufbau alternativer Ausführungsformen der thermoelektrischen Anordnung 100, insbesondere thermoelektrischen Sensoranordnung 101, wird auf die Figuren 2-14 verwiesen.

Figur 2 ist eine schematische Querschnittsansicht zur Erläuterung einer thermoelektrischen Anordnung, insbesondere thermoelektrische Sensoranordnung, und eines entsprechenden Herstellungsverfahrens gemäß einer ersten Ausführungsform der vorliegenden Erfindung.

In Figur 2 bezeichnet Bezugszeichen 100 die thermoelektrische Anordnung 100 bzw. das Bezugszeichen 101 die thermoelektrische Sensoranordnung 101. Die thermoelektrische Sensoranordnung 101 umfasst eine Leiterplatte 10, zwei zueinander einen Abstand A1 aufweisende thermoelektrische Bauelemente 20 mit einer Kaltseite K1 und einer Warmseite W1. Die zwei thermoelektrischen Bauelemente 20 sind zu der Leiterplatte 10 elektrisch kontaktiert. Ferner umfasst die thermoelektrische Sensoranordnung 101 ein Gehäuse 15 mit einer Abdeckung 30, wobei die Leiterplatte 10 und das zumindest eine thermoelektrische Bauelement 20 in dem Gehäuse 15 angeordnet sind und wobei die zwei thermoelektrischen Bauelemente 20 an der Kaltseite K1 mit einer wärmeabführenden Struktur 31 und an der Warmseite W1 mit einer der Abdeckung 30 abgewandten Seite des Gehäuses 15 mittels einer thermischen Leitereinrichtung 21, 22, 23, 24 verbunden sind. Hierbei ist, wie in der Figur 1 gezeigt, die Leiterplatte 10 durch die thermische Leitereinrichtung 21, 22, 23, 24 weitestgehend freistehend in dem Gehäuse angeordnet.

Die in Figur 2 gezeigte Leiterplatte 10 umfasst ferner thermische Kontaktstellen 13, welche vertikal durch die Leiterplatte 10 reichen, wobei das zumindest eine thermoelektrische Bauelement 20 auf der thermischen Kontaktstelle 13 angeordnet ist und die thermische Kontaktstellen 13 gemeinsam mit dem thermoelektrischen Bauelement 20 sowie der thermische Leitereinrichtung 21, 22, 23, 24 jeweils einen übereinander angeordneten Stapel S1 bilden. Des Weiteren umfasst die Leiterplatte 10 Komponenten 40, die beispielsweise als Sensor bzw. MEMS fungieren können. Die Komponenten 40 können auf einer Unterseite 11 und/oder auf einer Oberseite 12 der Leiterplatte 10 elektrisch über insbesondere weitere elektrische Schaltungen zu den thermoelektrischen Bauelementen 20 verbunden sein. Mit anderen Worten können die hier beschriebenen thermoelektrischen Bauelemente 20 als Energiequelle für die Komponenten 40 fungieren.

Wie in Figur 2 gezeigt, ist die Abdeckung 30 von dem Gehäuse 15 oder von der thermischen Leitereinrichtung 21, 22, 23, 24 durch zumindest ein Dichtungselement M1, D1 thermisch entkoppelt. Die Dichtungselemente M1, D1 umfassen ein thermisch isolierendes Material, so dass die Abdeckung 30 von dem Gehäuse 15 oder von der thermischen Leitereinrichtung 21, 22, 23, 24 thermisch entkoppelt ist. Das heißt, dass insbesondere die Abdeckung 30 ausschließlich mittels der Dichtungselemente D1 mit dem Gehäuse 15 in Kontakt stehen können. So lässt sich die Kaltseite K1 und die Warmseite W1 effizient einstellen, so dass sich möglichst schnell ein Temperaturgradient einstellt. Ferner lässt sich so insbesondere eine Dichtefunktion realisieren, um insbesondere Anforderungen für eine IP-Schutzklasse zu erfüllen. Die IP-Schutzklassen legen fest, in welchem Umfang ein elektrisches Bauteil Umwelteinflüssen ausgesetzt werden kann, ohne beschädigt zu werden oder ein Sicherheitsrisiko darzustellen. So lässt sich der zwischen Kaltseite und Warmseite ausbildende Temperaturgradient effizient einstellen.

Des Weiteren ist die Leiterplatte 10 mit den thermischen Kontaktstellen 13, auf welcher die thermoelektrischen Bauelemente 20 insbesondere mechanisch angebracht sein können, ausschließlich bzw. unmittelbar mittels der thermischen Leitereinrichtung 21, 22, 23, 24 innerhalb des Gehäuses 15 angeordnet.

Wie in Figur 2 gezeigt, ist die wärmeabführende Struktur 31 Teil eines Kühlkörpers 35, welcher die Abdeckung 30 überdeckt. Die thermische Leitereinrichtung 21, 22, 23, 24 ist hierbei durch Öffnungen 32 der Abdeckung 30 durchführbar. Das heißt, dass sich die in Figur 2 gezeigte Leitereinrichtung 21, 22 zumindest bereichsweise außerhalb des Gehäuses 15 befindet. Der Kühlkörper 35 und die Abdeckung 30 weisen einen vertikalen Abstand auf. So lässt sich Wärme über die Kaltseite des zumindest einen thermoelektrischen Bauelements effizient abführen.

Der Kühlkörper 35 der Figur 2 weist eine lamellenartige Struktur auf, die in eine Richtung entgegengesetzt zum Gehäuses 15 angeordnet sind. Insbesondere können die thermischen Kontaktstellen 13 an diagonal gegenüberliegenden Seiten der Leiterplatte 10 angeordnet sein. Somit lässt sich ein großer Abstand zwischen den beiden thermoelektrischen Bauelementen 20 einstellen.

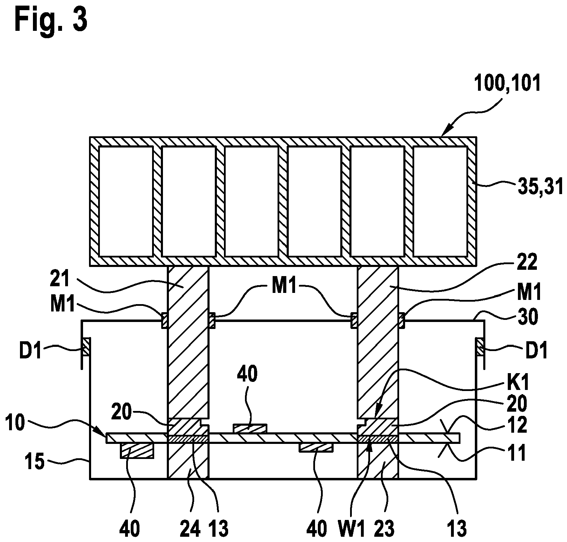

Figur 3 ist eine schematische Querschnittsansicht zur Erläuterung einer thermoelektrischen Anordnung, insbesondere thermoelektrische Sensoranordnung, und eines entsprechenden Herstellungsverfahrens gemäß einer zweiten Ausführungsform der vorliegenden Erfindung.

In Figur 3 ist eine thermoelektrische Anordnung 100, insbesondere die thermoelektrische Sensoranordnung 101, wie in Figur 2 gezeigt mit dem Unterschied, dass der Kühlkörper 35 als ein geschlossener Kühlkörper ausgebildet ist. Das heißt, dass die lamellenartig abstehenden Strukturen des Kühlkörpers 35 aus der Figur 2 nunmehr eine den Kühlkörper 35 bzw. die wärmeabführende Struktur 31 abdeckende Fläche aufweist. Durch einen derartig geschlossenen Kühlkörper 35 ist es möglich, eine dem Gehäuse abgewandte Oberseite des Kühlkörpers 35 beispielsweise zu beschriften. Ferner kann ein solcher Kühlkörper 35 bzw. die wärmeabführende Struktur 31 bei natürlicher Konvektion und vertikaler Einbaulage eine höhere thermische Performance als ein Kühlkörper ohne Deckel aufweisen, da ihre wirksame Oberfläche größer ist.

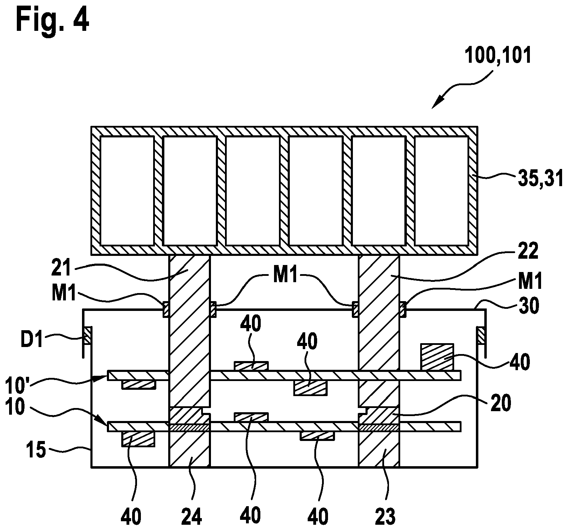

Figur 4 ist eine schematische Querschnittsansicht zur Erläuterung einer thermoelektrischen Anordnung, insbesondere thermoelektrische Sensoranordnung, und eines entsprechenden Herstellungsverfahrens gemäß einer dritten Ausführungsform der vorliegenden Erfindung.

Figur 4 zeigt die thermoelektrische Anordnung 100, insbesondere thermoelektrische Sensoranordnung 101, wie in Figur 3 gezeigt mit dem Unterschied, dass die thermoelektrische Sensoranordnung 101 eine weitere in vertikaler Richtung beabstandete Leiterplatte 10' mit weiteren Komponenten 40 umfasst. Die weitere Leiterplatte 10' kann beispielsweise über Steckkontakte oberhalb der Leiterplatte 10 aufgesteckt oder angelötet werden. So lässt sich auf einfache Art und Weise eine zusätzliche Funktionsintegration durchführen. Die weitere Leiterplatte 10' kann in derart ausgeführt sein, dass kein direkter mechanischen Kontakt zu den thermischen Leitereinrichtung 21, 22 besteht.

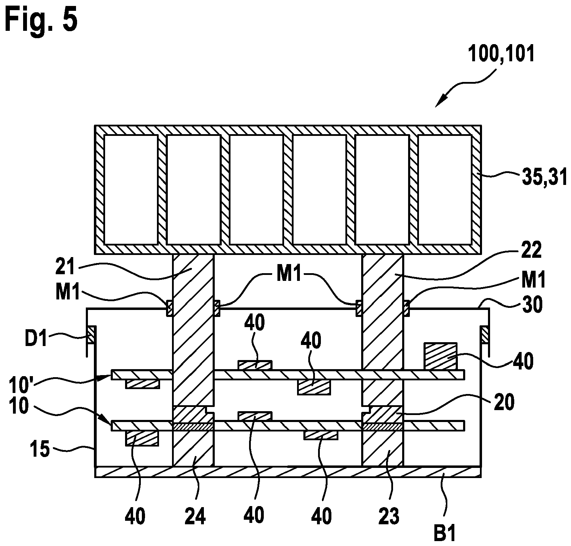

Figur 5 ist eine schematische Querschnittsansicht zur Erläuterung einer thermoelektrischen Anordnung, insbesondere thermoelektrische Sensoranordnung, und eines entsprechenden Herstellungsverfahrens gemäß einer vierten Ausführungsform der vorliegenden Erfindung.

Figur 5 basiert auf der in Figur 4 gezeigten thermoelektrischen Anordnung 100, insbesondere thermoelektrische Sensoranordnung 101, mit dem Unterschied, dass eine Bodenfläche B1 des Gehäuses 15 ein thermisch leitfähiges Material umfasst und somit die Bodenfläche B1 als thermischer Leiter fungiert. Bevorzugt bildet die Bodenfläche B1 des Gehäuses 15 mit der zu der Warmseite W1 zugeordneten thermischen Leitereinrichtung 23, 24 einen direkten Kontakt aus. So lässt sich eine Wärmespreizung an der Bodenfläche B1 des Gehäuses 15 verbessern. Hierdurch resultiert ein größerer Temperaturgradient im Betrieb der thermoelektrischen Anordnung 100, insbesondere der thermoelektrischen Sensoranordnung 101.

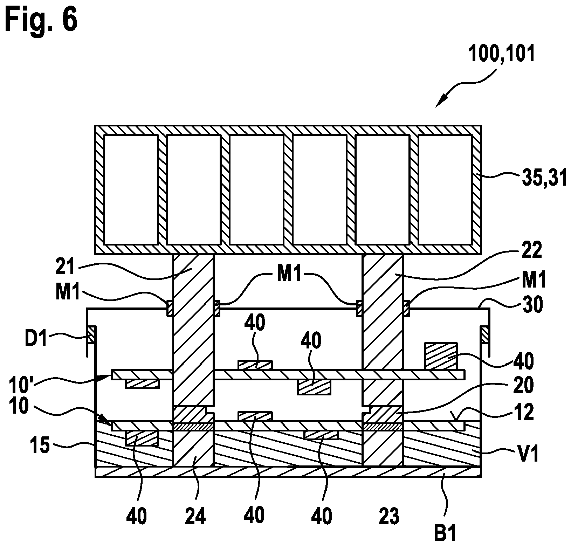

Figur 6 ist eine schematische Querschnittsansicht zur Erläuterung einer thermoelektrischen Anordnung, insbesondere thermoelektrische Sensoranordnung, und eines entsprechenden Herstellungsverfahrens gemäß einer fünften Ausführungsform der vorliegenden Erfindung.

Figur 6 basiert auf der in Figur 5 gezeigten thermoelektrischen Anordnung 100, insbesondere der thermoelektrischen Sensoranordnung 101, mit dem Unterschied, dass in dem Gehäuse 15 eine Vergussmasse V1 angeordnet ist und die Vergussmasse V1 die Leiterplatte 10 mechanisch stabilisiert. Die Vergussmasse V1 schließt in lateraler Richtung beispielsweise bündig mit der Oberseite 12 der Leiterplatte 10 ab. Ferner kann durch die Vergussmasse V1 das Gehäuse 15 mechanisch stabilisiert werden, wodurch ein zusätzlicher Schutz gegen Feuchtigkeit gewährleistet werden kann.

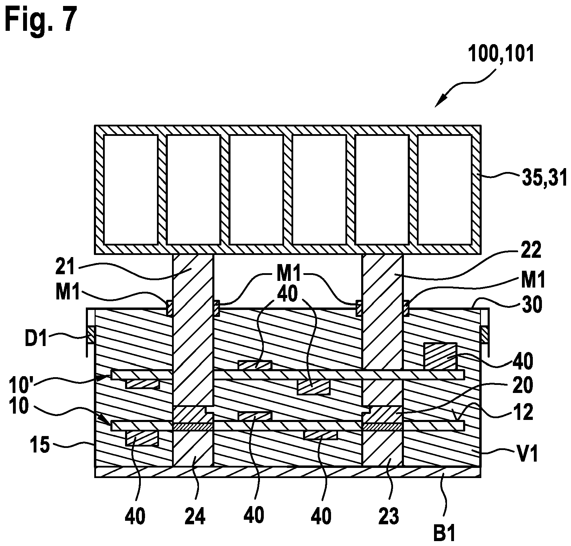

Figur 7 ist eine schematische Querschnittsansicht zur Erläuterung einer thermoelektrischen Anordnung, insbesondere thermoelektrische Sensoranordnung, und eines entsprechenden Herstellungsverfahrens gemäß einer sechsten Ausführungsform der vorliegenden Erfindung.

Figur 7 basiert auf der in Figur 6 gezeigten thermoelektrischen Anordnung 100, insbesondere der thermoelektrischen Sensoranordnung 101, mit dem Unterschied, dass das Gehäuse 15 vollständig mit der Vergussmasse V1 befüllt ist. Hierbei weist die Vergussmasse V1 eine sehr niedrige Wärmeleitfähigkeit auf, um insbesondere Kurzschlüsse zu vermeiden und die Funktionalität der thermoelektrischen Bauteile zu begünstigen. Insbesondere ist denkbar, dass die thermoelektrischen Bauelemente 20 vor Befüllen mit der Vergussmasse V1 mit einem Underfill geschützt werden. So lässt sich ein undefiniertes Eindringen der Vergussmasse V1 in Zwischenräumen der thermoelektrischen Bauelemente 20 verhindern.

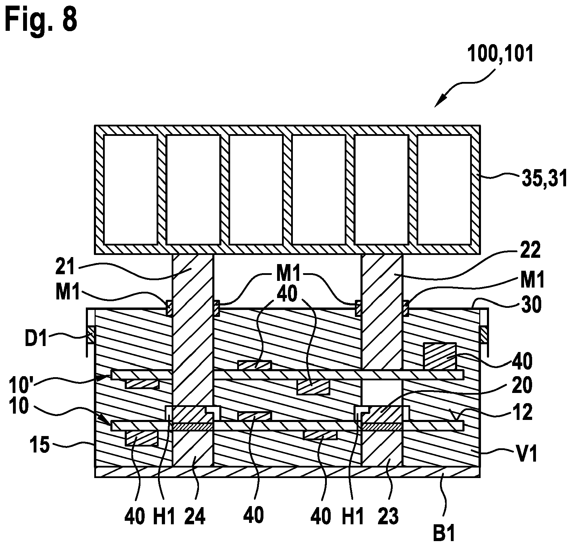

Figur 8 ist eine schematische Querschnittsansicht zur Erläuterung einer thermoelektrischen Anordnung, insbesondere thermoelektrische Sensoranordnung, und eines entsprechenden Herstellungsverfahrens gemäß einer siebten Ausführungsform der vorliegenden Erfindung.

Figur 8 basiert auf der in Figur 7 gezeigten thermoelektrischen Anordnung 100, insbesondere der thermoelektrischen Sensoranordnung 101 mit dem Unterschied, dass die thermoelektrischen Bauelemente 20 sich innerhalb der Vergussmasse V1 in einem Hohlraum H1 befinden. Mit anderen Worten sind die thermoelektrischen Bauelemente 20 der Figur 8 frei von einem Material der Vergussmasse V1. Dies kann beispielsweise dadurch erreicht werden, dass vor Befüllen des Gehäuses 15 mit der Vergussmasse V1 die thermoelektrischen Bauelemente 20 mit einem thermisch zersetzbaren Material zumindest bereichsweise umschlossen werden. Das thermisch zersetzbare Material kann nach Einbringen der Vergussmasse V1 über einen thermischen Schritt zersetzt werden. Alternativ zum thermisch zersetzbaren Material sind ebenfalls anders nachträglich entfernbare Materialien denkbar.

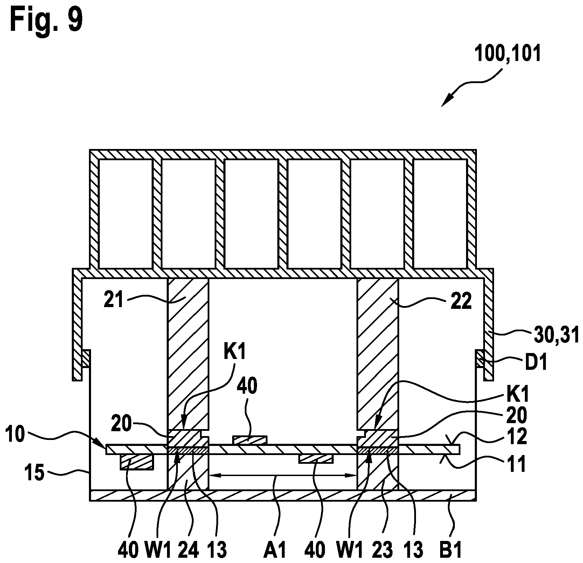

Figur 9 ist eine schematische Querschnittsansicht zur Erläuterung einer thermoelektrischen Anordnung, insbesondere thermoelektrische Sensoranordnung, und eines entsprechenden Herstellungsverfahrens gemäß einer achten Ausführungsform der vorliegenden Erfindung.

Figur 9 zeigt die in Figur 2 gezeigte thermoelektrische Sensoranordnung 101 bzw. thermoelektrische Anordnung 100 mit dem Unterschied, dass die wärmeabführende Struktur 31 Teil der Abdeckung 30 ist, welche das Gehäuse 15 überdeckt. Das heißt, dass die wärmeableitende Struktur 31 zwei Funktionen aufweist, die der Abdeckung 30 und die des Kühlkörpers 35 (vergleiche beispielsweise Fig. 2). Mit anderen Worten weist die wärmeabführende Struktur 31 keine Öffnungen 32 auf und kann zum einen das Gehäuse 15 abdecken und gleichzeitig als Kühlkörper 35 fungieren. Die wärmeabführende Struktur 31 kann mittels eines thermisch gut leitfähigen Klebstoffs, thermisch gut leitender Pads bzw. auch Pasten oder Lotpaste mit der thermischen Leitereinrichtung 21, 22 kontaktiert werden. Beispielsweise umfassen die Pads und Pasten ein thermisch leitfähiges Ausgleichmaterial, so dass stoffschlüssige und toleranzausgleichende Kontakte realisierbar sind. Ferner kann die Leitereinrichtung 21, 22 auch ein fester Bestandteil der wärmeabführenden Struktur 31 sein. So lassen sich insbesondere Übergangswiderstände minimieren.

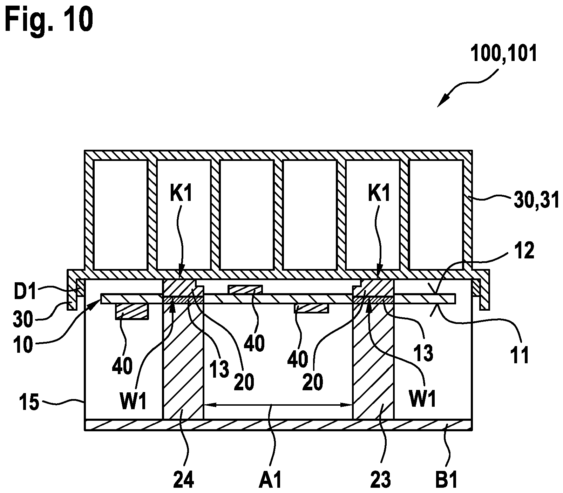

Figur 10 ist eine schematische Querschnittsansicht zur Erläuterung einer thermoelektrischen Anordnung, insbesondere thermoelektrische Sensoranordnung, und eines entsprechenden Herstellungsverfahrens gemäß einer neunten Ausführungsform der vorliegenden Erfindung.

Figur 10 basiert auf der in Figur 9 gezeigten thermoelektrischen Sensoranordnung 101 bzw. thermoelektrischen Anordnung 100 mit dem Unterschied, dass die wärmeabführenden Struktur 31 direkt mit der Kaltseite K1 der beiden thermoelektrischen Bauelemente 20 verbunden ist. So lässt sich eine platzsparende und kompakte thermoelektrischen Sensoranordnung 101 bzw. thermoelektrischen Anordnung 100 bereitstellen.

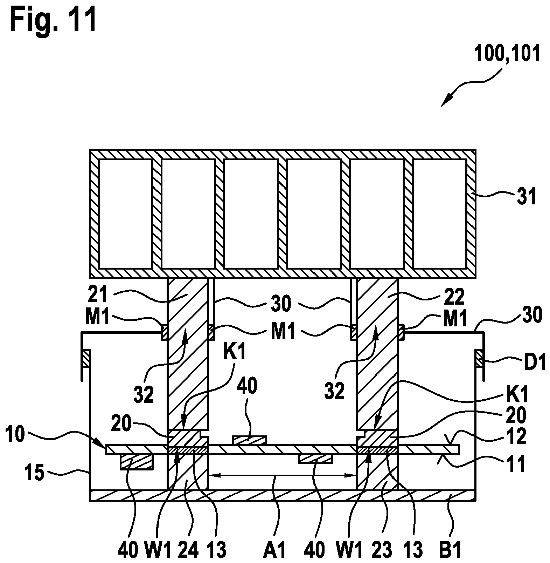

Figur 11 ist eine schematische Querschnittsansicht zur Erläuterung einer thermoelektrischen Anordnung, insbesondere thermoelektrische Sensoranordnung, und eines entsprechenden Herstellungsverfahrens gemäß einer zehnten Ausführungsform der vorliegenden Erfindung.

Figur 11 basiert auf der in Figur 2 gezeigten thermoelektrischen Anordnung 100, insbesondere der thermoelektrischen Sensoranordnung 101, mit dem Unterschied, dass die Abdeckung 30 zumindest bereichsweise parallel zu der thermischen Leitereinrichtung 21, 22 verläuft und mit der wärmeabführenden Struktur 31 bzw. Abdeckung 30 verbunden ist.

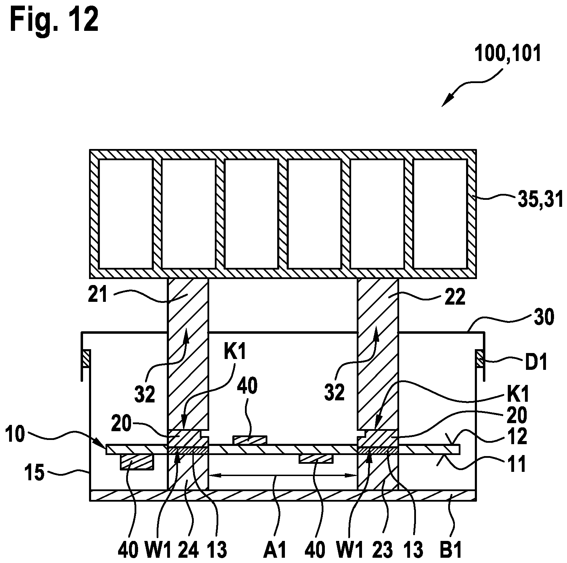

Figur 12 ist eine schematische Querschnittsansicht zur Erläuterung einer thermoelektrischen Anordnung, insbesondere thermoelektrische Sensoranordnung, und eines entsprechenden Herstellungsverfahrens gemäß einer elften Ausführungsform der vorliegenden Erfindung.

Figur 12 basiert auf der in Figur 2 gezeigten thermoelektrischen Anordnung 100, insbesondere der thermoelektrischen Sensoranordnung 101, mit dem Unterschied, dass die Abdeckung 30 ein im Wesentlichen gleiches Material wie die thermische Leitereinrichtung 21, 22, 23, 24 umfasst. So lässt sich eine wärmeabführende Fläche zusätzlich vergrößern, wobei die Abdeckung 30 mittels der Dichtungselemente D1 von dem Gehäuse 15 thermisch entkoppelt ist.

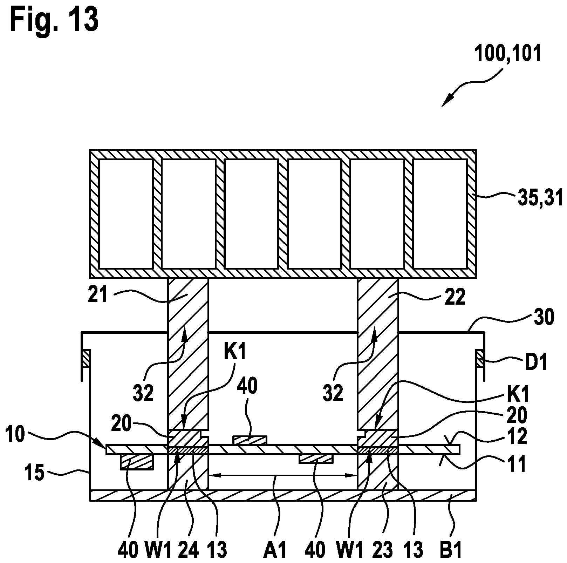

Figur 13 ist eine schematische Querschnittsansicht zur Erläuterung einer thermoelektrischen Anordnung, insbesondere thermoelektrische Sensoranordnung, und eines entsprechenden Herstellungsverfahrens gemäß einer zwölften Ausführungsform der vorliegenden Erfindung.

Figur 13 basiert auf der in Figur 2 gezeigten thermoelektrischen Anordnung 100, insbesondere der thermoelektrischen Sensoranordnung 101, mit dem Unterschied, dass das Gehäuse 15 sowie die Abdeckung 30 ein thermisch gut leitendes Material umfassen. In dieser Ausführungsform ist es erforderlich, dass die Dichtungselemente D1 eine thermische Isolation zwischen dem Gehäuse 15 und der Abdeckung 30 gewährleisten, um ein Ausbilden des Temperaturgradienten an den thermoelektrischen Bauelementen 20 zu begünstigen.

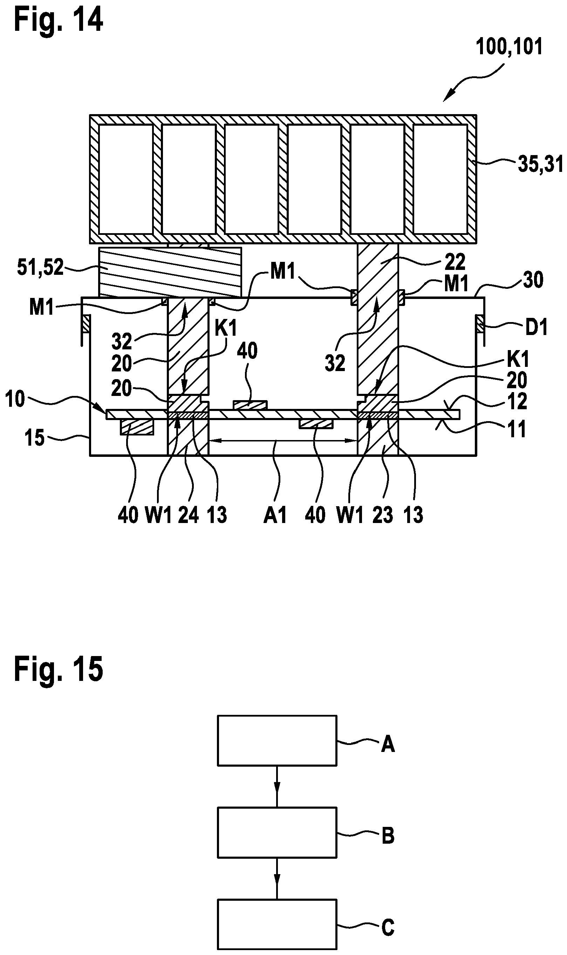

Figur 14 ist eine schematische Querschnittsansicht zur Erläuterung einer thermoelektrischen Anordnung, insbesondere thermoelektrische Sensoranordnung, und eines entsprechenden Herstellungsverfahrens gemäß einer dreizehnten Ausführungsform der vorliegenden Erfindung.

Figur 14 basiert auf der in Figur 2 gezeigten thermoelektrischen Anordnung 100, insbesondere der thermoelektrischen Sensoranordnung 101, mit dem Unterschied, dass eine Primärbatterie 51 oder ein wieder aufladbarer Akku 52 zwischen der wärmeabführenden Struktur 31 bzw. Kühlkörper 35 und der Abdeckung 30 angeordnet ist. Die Primärbatterie 51 oder der wieder aufladbare Akku 52 kann beispielsweise auf der Abdeckung 30 angeordnet sein. Es ist ebenso eine Integration der Primärbatterie 51 oder des wieder aufladbaren Akkus 52 in den Kühlkörper 35 bzw. in die wärmeabführende Struktur 31 denkbar. So lässt sich die Primärbatterie 51 oder der wieder aufladbare Akku 52 in einem Bereich mit im Wesentlichen kühler Temperatur anordnen, da mittels des Kühlkörpers 35 bzw. der wärmeabführenden Struktur 31 die im Betrieb entstehende Wärme schnell abführbar ist.

Figur 15 ist ein Flussdiagramm zur Erläuterung des Herstellungsverfahrens gemäß den hier beschriebenen alternativen Ausführungsformen gemäß Figuren 1-14.

Das Verfahren zum Herstellen einer thermoelektrischen Anordnung 100, insbesondere einer thermoelektrischen Sensoranordnung 101 umfasst die Schritte A bis C. Im Schritt A wird die Leiterplatte 10 bereitgestellt. Im Schritt B wird zumindest das zumindest eine thermoelektrische Bauelement 20 mit der Kaltseite K1 und der Warmseite W1 bereitgestellt. Die thermoelektrischen Bauelemente 20 werden hierbei mit der Leiterplatte 10 elektrisch kontaktiert. In einem Schritt C werden das Gehäuse 15 mit der Abdeckung 30 bereitgestellt, wobei die Leiterplatte 10 und die thermoelektrischen Bauelemente 20 in dem Gehäuse 15 angeordnet werden und wobei die thermoelektrischen Bauelement 20 an der Kaltseite K1 mit der wärmeabführenden Struktur 31 und an der Warmseite W1 mit einer der Abdeckung 30 abgewandten Seite des Gehäuses 15 mittels der thermischen Leitereinrichtung 21, 22, 23, 24 verbunden wird und die Leiterplatte 10 mittels der thermische Leitereinrichtung 21, 22, 23, 24 weitestgehend freistehend in dem Gehäuse 15 angeordnet wird.

Obwohl die vorliegende Erfindung anhand bevorzugter Ausführungsbeispiele beschrieben wurde, ist sie darauf nicht beschränkt. Insbesondere sind die genannten Materialien und Anordnungen nur beispielhaft und nicht auf die erläuterten Beispiele beschränkt.

## Patentansprüche

1. Thermoelektrische Anordnung (100), insbesondere thermoelektrische Sensoranordnung (101), mit:
zumindest einer Leiterplatte (10);
zumindest einem thermoelektrischen Bauelement (20) mit einer Kaltseite (K1) und einer Warmseite (W1), welches zu der zumindest einen Leiterplatte (10) elektrisch kontaktiert ist;
einem Gehäuse (15) mit einer Abdeckung (30),
wobei die Leiterplatte (10) und das zumindest eine thermoelektrische Bauelement (20) in dem Gehäuse (15) angeordnet sind; und
wobei das zumindest eine thermoelektrische Bauelement (20) an der Kaltseite (K1) mit einer wärmeabführenden Struktur (31) und an der Warmseite (W1) mit einer der Abdeckung (30) abgewandten Seite des Gehäuses (15) mittels einer thermischen Leitereinrichtung (21, 22, 23, 24) verbunden ist; **dadurch gekennzeichnet, daß** die zumindest eine Leiterplatte (10) durch die thermische Leitereinrichtung (21, 22, 23, 24) weitestgehend freistehend in dem Gehäuse (15) angeordnet ist.

2. Thermoelektrische Anordnung (100) nach Anspruch 1, wobei das zumindest eine thermoelektrische Bauelement (20) auf der zumindest einen Leiterplatte (10) mechanisch angebracht ist.

3. Thermoelektrische Anordnung (100) nach Anspruch 1 oder 2, wobei das zumindest eine thermoelektrische Bauelement (20) unmittelbar mit der thermischen Leitereinrichtung (21, 22, 23, 24) mechanisch kontaktiert ist.

4. Thermoelektrische Anordnung (100) nach einem der vorhergehenden Ansprüche, wobei die zumindest eine Leiterplatte (10) thermische Kontaktstellen (13) umfasst, welche vertikal durch die zumindest eine Leiterplatte (10) reichen, das zumindest eine thermoelektrische Bauelement (20) auf der thermischen Kontaktstelle (13) angeordnet ist und die thermische Kontaktstelle (13) gemeinsam mit dem zumindest einen thermoelektrischen Bauelement (20) und der thermische Leitereinrichtung (21, 22, 23, 24) einen übereinander angeordneten Stapel (S1) bildet.

5. Thermoelektrische Anordnung (100) nach Anspruch 4, wobei die thermischen Kontaktstellen (13) an diagonal gegenüberliegenden Seiten der Leiterplatte (10) angeordnet sind.

6. Thermoelektrische Anordnung (100) nach einem der vorhergehenden Ansprüche, wobei die wärmeabführende Struktur (31) Teil eines Kühlkörpers (35) ist, welcher die Abdeckung (30) überdeckt und wobei die thermische Leitereinrichtung (21, 22, 23, 24) durch zumindest eine Öffnung (32) der Abdeckung (30) durchführbar ist.

7. Thermoelektrische Anordnung (100) nach Anspruch 6, wobei die Abdeckung (30) von dem Gehäuse (15) oder von der thermischen Leitereinrichtung (21, 22, 23, 24) durch zumindest ein Dichtungselement (M1, D1) thermisch entkoppelt ist.

8. Thermoelektrische Anordnung (100) nach einem der vorhergehenden Ansprüche, wobei die wärmeabführende Struktur (31) Teil der Abdeckung (30) ist, welche das Gehäuse (15) überdeckt.

9. Thermoelektrische Anordnung (100) nach einem der vorhergehenden Ansprüche, wobei in dem Gehäuse (15) eine Vergussmasse (V1) angeordnet ist und die Vergussmasse (V1) die Leiterplatte (10) mechanisch stabilisiert.

10. Thermoelektrische Anordnung (100) nach einem der vorhergehenden Ansprüche, wobei das Gehäuse (15) und/oder die Abdeckung (30) ein thermisch-leitfähiges Material umfassen.

11. Verfahren zum Herstellen einer thermoelektrischen Anordnung (100), insbesondere einer thermoelektrischen Sensoranordnung (101), mit den Schritten:
A) Bereitstellen zumindest einer Leiterplatte (10);
B) Bereitstellen zumindest eines thermoelektrischen Bauelement (20) mit einer Kaltseite (K1) und einer Warmseite (W1), welches zu der zumindest einen Leiterplatte (10) elektrisch kontaktiert wird;
C) Bereitstellen eines Gehäuses (15) mit einer Abdeckung (30);
wobei die zumindest eine Leiterplatte (10) und das zumindest eine thermoelektrische Bauelement (20) in dem Gehäuse (15) angeordnet werden; und
wobei das zumindest eine thermoelektrische Bauelement (20) an der Kaltseite (K1) mit einer wärmeabführenden Struktur (31) und an der Warmseite (W1) mit einer der Abdeckung (30) abgewandten Seite des Gehäuses (15) mittels einer thermischen Leitereinrichtung (21, 22, 23, 24) verbunden wird und die zumindest eine Leiterplatte (10) durch die thermische Leitereinrichtung (21, 22, 23, 24) weitestgehend freistehend in dem Gehäuse (15) angeordnet wird.

## Claims

1. Thermoelectric arrangement (100), in particular thermoelectric sensor arrangement (101), having:
at least one printed circuit board (10);
at least one thermoelectric component (20) having a cold side (K1) and a warm side (W1), which component is in electrical contact with the at least one printed circuit board (10);
a housing (15) having a cover (30),
wherein the printed circuit board (10) and the at least one thermoelectric component (20) are arranged in the housing (15); and
wherein the at least one thermoelectric component (20) is connected to a heat-dissipating structure (31) on the cold side (K1) and is connected to a side of the housing (15) facing away from the cover (30) on the warm side (W1) by means of a thermal conductor device (21, 22, 23, 24); **characterized in that**
the at least one printed circuit board (10) is arranged in the housing (15) in a free-standing manner as far as possible by means of the thermal conductor device (21, 22, 23, 24).

2. Thermoelectric arrangement (100) according to Claim 1, wherein the at least one thermoelectric component (20) is mechanically fitted to the at least one printed circuit board (10).

3. Thermoelectric arrangement (100) according to Claim 1 or 2, wherein the at least one thermoelectric component (20) is in direct mechanical contact with the thermal conductor device (21, 22, 23, 24).

4. Thermoelectric arrangement (100) according to one of the preceding claims, wherein the at least one printed circuit board (10) comprises thermal contact points (13) which extend vertically through the at least one printed circuit board (10), the at least one thermoelectric component (20) is arranged on the thermal contact point (13) and the thermal contact point (13) forms, together with the at least one thermoelectric component (20) and the thermal conductor device (21, 22, 23, 24), a stack (S1) arranged above one another.

5. Thermoelectric arrangement (100) according to Claim 4, wherein the thermal contact points (13) are arranged on diagonally opposite sides of the printed circuit board (10) .

6. Thermoelectric arrangement (100) according to one of the preceding claims, wherein the heat-dissipating structure (31) is part of a heat sink (35) which covers the cover (30), and wherein the thermal conductor device (21, 22, 23, 24) can be guided through at least one opening (32) in the cover (30).

7. Thermoelectric arrangement (100) according to Claim 6, wherein the cover (30) is thermally decoupled from the housing (15) or from the thermal conductor device (21, 22, 23, 24) by means of at least one sealing element (M1, D1).

8. Thermoelectric arrangement (100) according to one of the preceding claims, wherein the heat-dissipating structure (31) is part of the cover (30) which covers the housing (15).

9. Thermoelectric arrangement (100) according to one of the preceding claims, wherein a potting compound (V1) is arranged in the housing (15) and the potting compound (V1) mechanically stabilizes the printed circuit board (10) .

10. Thermoelectric arrangement (100) according to one of the preceding claims, wherein the housing (15) and/or the cover (30) comprise(s) a thermally conductive material.

11. Method for producing a thermoelectric arrangement (100), in particular a thermoelectric sensor arrangement (101), having the steps of:
A) providing at least one printed circuit board (10);
B) providing at least one thermoelectric component (20) having a cold side (K1) and a warm side (W1), which component is in electrical contact with the at least one printed circuit board (10);
C) providing a housing (15) having a cover (30);
wherein the at least one printed circuit board (10) and the at least one thermoelectric component (20) are arranged in the housing (15); and
wherein the at least one thermoelectric component (20) is connected to a heat-dissipating structure (31) on the cold side (K1) and is connected to a side of the housing (15) facing away from the cover (30) on the warm side (W1) by means of a thermal conductor device (21, 22, 23, 24), and the at least one printed circuit board (10) is arranged in the housing (15) in a free-standing manner as far as possible by means of the thermal conductor device (21, 22, 23, 24).

## Revendications

1. Ensemble thermoélectrique (100), notamment ensemble capteur thermoélectrique (101), comprenant :
au moins une carte de circuit imprimé (10) ;
au moins un composant thermoélectrique (20) présentant un côté froid (K1) et un côté chaud (W1), lequel composant est en contact électrique avec ladite au moins une carte de circuit imprimé (10) ;
un boîtier (15) pourvu d'un élément de recouvrement (30),
dans lequel la carte de circuit imprimé (10) et ledit au moins un composant thermoélectrique (20) sont disposés dans le boîtier (15) ; et
dans lequel ledit au moins un composant thermoélectrique (20) est relié du côté froid (K1) à une structure de dissipation de chaleur (31) et du côté chaud (W1) à un côté du boîtier (15) qui est tourné à l'opposé de l'élément de recouvrement (30) au moyen d'un dispositif conducteur thermique (21, 22, 23, 24) ;
**caractérisé en ce que** ladite au moins une carte de circuit imprimé (10) est disposée dans le boîtier (15) de manière sensiblement autonome au moyen du dispositif conducteur thermique (21, 22, 23, 24).

2. Ensemble thermoélectrique (100) selon la revendication 1, dans lequel ledit au moins un composant thermoélectrique (20) est fixé mécaniquement à ladite au moins une carte de circuit imprimé (10).

3. Ensemble thermoélectrique (100) selon la revendication 1 ou 2, dans lequel ledit au moins un composant thermoélectrique (20) est en contact mécanique direct avec le dispositif conducteur thermique (21, 22, 23, 24).

4. Ensemble thermoélectrique (100) selon l'une des revendications précédentes, dans lequel ladite au moins une carte de circuit imprimé (10) comprend des points de contact thermiques (13) qui s'étendent verticalement à travers ladite au moins une carte de circuit imprimé (10), ledit au moins un composant thermoélectrique (20) est disposé sur les points de contact thermiques (13), et le point de contact thermique (13) forme avec ledit au moins un composant thermoélectrique (20) et le dispositif conducteur thermique (21, 22, 23, 24) un empilement superposé (S1).

5. Ensemble thermoélectrique (100) selon la revendication 4, dans lequel les points de contact thermiques (13) sont disposés sur des côtés diagonalement opposés de la carte de circuit imprimé (10).

6. Ensemble thermoélectrique (100) selon l'une des revendications précédentes, dans lequel la structure de dissipation de chaleur (31) fait partie d'un corps de refroidissement (35) qui recouvre l'élément de recouvrement (30) et dans lequel le dispositif conducteur thermique (21, 22, 23, 24) peut être amené à passer à travers au moins une ouverture (32) de l'élément de recouvrement (30).

7. Ensemble thermoélectrique (100) selon la revendication 6, dans lequel l'élément de recouvrement (30) est découplé thermiquement du boîtier (15) ou du dispositif conducteur thermique (21, 22, 23, 24) par au moins un élément d'étanchéité (M1, D1).

8. Ensemble thermoélectrique (100) selon l'une des revendications précédentes, dans lequel la structure de dissipation de chaleur (31) fait partie de l'élément de recouvrement (30) recouvrant le boîtier (15).

9. Ensemble thermoélectrique (100) selon l'une des revendications précédentes, dans lequel une masse d'enrobage (V1) est disposée dans le boîtier (15) et la masse d'enrobage (V1) stabilise mécaniquement la carte de circuit imprimé (10).

10. Ensemble thermoélectrique (100) selon l'une des revendications précédentes, dans lequel le boîtier (15) et/ou l'élément de recouvrement (30) sont constitués d'un matériau thermiquement conducteur.

11. Procédé de fabrication d'un ensemble thermoélectrique (100), notamment d'un ensemble capteur thermoélectrique (101), comprenant les étapes consistant à :
A) prévoir au moins une carte de circuit imprimé (10) ;
B) prévoir au moins un composant thermoélectrique (20) présentant un côté froid (K1) et un côté chaud (W1), lequel composant thermoélectrique est en contact électrique avec ladite au moins une carte de circuit imprimé (10) ;
C) prévoir un boîtier (15) pourvu d'un élément de recouvrement (30) ;
dans lequel ladite au moins une carte de circuit imprimé (10) et ledit au moins un composant thermoélectrique (20) sont disposés dans le boîtier (15) ; et
dans lequel ledit au moins un composant thermoélectrique (20) est relié du côté froid (K1) à une structure de dissipation de chaleur (31) et du côté chaud (W1) à un côté du boîtier (15) qui est tourné à l'opposé de l'élément de recouvrement (30) au moyen d'un dispositif conducteur thermique (21, 22, 23, 24) et ladite au moins une carte de circuit imprimé (10) est disposée dans le boîtier (15) de manière sensiblement autonome au moyen du dispositif conducteur thermique (21, 22, 23, 24).
